# EUROPÄISCHE PATENTSCHRIFT

(11) **EP 0 966 552 B1**
(45) Veröffentlichungstag und Bekanntmachung des Hinweises auf die Patenterteilung: **03.07.2002**
(21) Anmeldenummer: 98962180.0
(22) Anmeldetag: 26.10.1998
(51) Int. Cl.: C23C 14/50, C23C 14/48, C23C 8/36, H01J 37/32

(54) **DREHVORRICHTUNG ZUR PLASMA-IMMERSIONS-GESTÜTZTEN BEHANDLUNG VON SUBSTRATEN**
ROTATING DEVICE FOR PLASMA IMMERSION SUPPORTED TREATMENT OF SUBSTRATES
DISPOSITIF DE ROTATION POUR LE TRAITEMENT DE SUBSTRATS ACTIVE PAR IMMERSION DANS UN PLASMA

(30) Priorität: 17.11.1997 DE 19750909
(43) Veröffentlichungstag der Anmeldung: 29.12.1999
(73) Patentinhaber: ROBERT BOSCH GMBH, 70442 Stuttgart (DE)
(72) Erfinder: NEIDHARDT, Ronald, D-70195 Stuttgart (DE); FORGET, Jeanne, D-70195 Stuttgart (DE); KOHLHOF, Karl, D-51069 Köln (DE); SCHOSER, Siegmar, D-88639 Wald (DE)
(86) Internationale Anmeldenummer: DE9803128
(87) Internationale Veröffentlichungsnummer: WO9925893

(56) Entgegenhaltungen:
- EP-A- 0 729 173
- GB-A- 2 133 764
- US-A- 4 118 624

## Beschreibung

### Stand der Technik

Die Erfindung betrifft eine Drehvorrichtung, insbesondere zur plasma-immersions-gestützten Behandlung dreidimensional geformter Werkstücke, nach dem Oberbegriff des Patentanspruchs 1 und ein diese Drehvorrichtung verwendendes Behandlungsverfahren gemäß dem unabhängigen Anspruch 11. Eine derartige Drehvorrichtung ist aus EP-0729 173 A1 bekannt.

In vielen Industriezweigen werden heute bereits Oberflächeneigenschaften von Produkten gezielt durch Abscheidung oder Umwandlung dünner Schichten im Vakuum modifiziert. Neben auftragenden Verfahren, die Atome oder Moleküle aus der Gasphase oder durch Zerstäuben oder Verdampfung mittels einer Heizung oder durch Elektronenstrahl oder Lichtbogen auf einer Produktoberfläche auftragen bzw. abscheiden, sind auch nicht-auftragende Verfahren bekannt, wie Wärme- und Plasmabehandlung in inerten oder reaktiven Gasen, Elektronen- und Laserbehandlungen oder auch die Implantation inerter, reaktiver, nichtmetallischer und auch metallischer Ionen in ein Substratmaterial hinein.

Es sind bereits Verfahren und Vorrichtungen -bekannt, die eine Ionen- bzw. Plasmabehandlung mit einer Beschichtung kombinieren. Diese Verfahren bilden den heutigen Standard zur Niedertemperaturabscheidung von Legierungsschichten mit hohem Schmelzpunkt, wie sie z.B. zum Schutz gegen Verschleiß mechanischer Bauteile, z.B. hoch beanspruchter metallischer Bauteile dienen, oder auch zur Vergütung optischer Komponenten, beispielsweise Kameraoptiken und Brillengläser. Hierbei wird die Umwandlung der eingebrachten Ionenenergie in Wärme ausgenutzt. Die Ionen werden entweder in Ionenstrahlquellen mit oder ohne Massentrennung oder in Plasmen erzeugt, die entweder in zusätzlichen Plasmaquellen mit Gleichstrom, hochfrequenten Strömen oder mit Mikrowellen angeregt werden, oder die bei plasmagestützten Beschichtungsprozessen ohnehin vorhanden sind.

In den erwähnten Ionenstrahlquellen werden Ionen vorbeschleunigt und einseitig auf die zu behandelnden Werkstücke gerichtet. Dabei erzielt man eine Behandlung oder Beschichtung von im wesentlichen flachen Substratoberflächen. Dagegen legt man bei den zuletzt genannten Plasmatechnologien negative elektrische Gleichspannungen an die Werkstücke an, die von ca. 50 V bis 1 kV reichen und durch die die Ionen allseitig und ungerichtet nicht nur auf im wesentlichen flache sondern auch auf die Oberfläche dreidimensional geformter Bauteile gelenkt werden. Bei geringen Ionen-Energien unter 1 keV sind Implantationseffekte, wie Dotieren, athermisches Legieren von Ungleichgewichtsphasen, Grenzflächenvermischen zur Haftfestigkeitssteigerung oder beschleunigte Diffusion über ionenstrahlinduzierte Strukturdefekte unwahrscheinlich und somit technisch nicht ausnutzbar. Die dazu geeignete klassische Ionenstrahlbehandlung findet jedoch in kostenempfindlichen Produktionsbereichen (wie dem Maschinenbau) aus Wirtschaftlichkeitsgründen nur Anwendungen für bestimmte, eng begrenzte Produktbereiche.

Eine neue kostengünstige plasma-immersions-gestützte Ionen-Implantationstechnologie haben J. Conrad, J. L. Radke, R. A. Dodd, F. J. Worzala, entwickelt und in J. Applied Physics 62 (1987), S. 4591, beschrieben (vgl. auch das US-Patent 4 764 394 von J. Conrad). Bei dieser sog. Plasma-Immersions-Ionenimplantation, auch PII genannt, tauchen die Werkstücke, wie bei der ionen- oder plasmagestützten Beschichtung in ein Plasma ein (Immersion). Im Unterschied zu diesem Verfahren beträgt die angelegte negative Spannung einige kV bis zu wenigen 100 kV, wodurch die extrahierten Ionen nicht nur an der Werkstückoberfläche reagieren sondern unter sie implantiert werden und oben genannten Implantationseffekte initiieren. Die Hochspannung liegt in Form kurzer Pulse von einigen µs bis zu einigen 100 µs Länge bei einer Wiederholfrequenz von einigen 100 Hz bis einigen kHz an, um den Wärmeeintrag zu steuern und gleichzeitig den Aufwand für die Hochspannungsversorgung minimieren zu können. Ein weiterer Vorteil dieser Pulstechnik besteht in dem immer wieder neu gestarteten Aufbau der kathodischen Plasmarandschicht entlang der Werkstückkontur, in der der zur Ionenbeschleunigung wesentliche Spannungsabfall erfolgt. Gleich nach Pulsstart ist so immer ein senkrecht auf die jeweilige Probenoberfläche gerichteter Ionenbeschuß gewährleistet und dies auch in Vertiefungen oder an Erhebungen strukturierter Geometrien. Ein unzureichender oder streifender Ionenbeschuß, wie er ungünstigerweise bei Ionenstrahlbehandlungen auftritt, erfolgt bei PII zum Ende sehr langer Pulse, wenn sich die Plasma-Randschicht so weit von der Plasmaoberfläche ausgedehnt hat, daß eine einhüllende Plasmafront entstanden ist, die nicht mehr überall der Probenkontur folgt. Diese Plasmarandschicht breitet sich sehr schnell aus, z.B. innerhalb einiger Mikrosekunden.

Die bisher bekannt gewordenen PII-Prozesse werden lediglich zur Ionenimplantation, beispielsweise zum Nitrieren von Stählen oder zum Dotieren von Halbleitern, eingesetzt. Dabei wird meist ein separates Plasma durch selbständige Gleichspannungsentladung oder durch Hochfrequenz- oder Mikrowellenanregung erzeugt, in das die reaktiven Komponenten zumeist gasförmig eingelassen werden.

J. Conrad schlägt in seinem oben erwähnten US-Patent 4 764 394 zur Durchführung des PII-Behandlungsverfahrens eine Apparatur vor, die im wesentlichen aus einer stark evakuierten Behandlungskammer mit elektrisch leitfähigen Wänden, beispielsweise aus rostfreiem Stahl, besteht. Sämtliche leitenden Wände dieser Kammer sind elektrisch miteinander und mit Erde verbunden.

Ein dreidimensional geformtes Werkstück ist auf einem elektrisch leitenden ruhenden Podest, beabstandet von den Kammerwänden, aufgelegt, und das leitende Podest ist mit einem elektrisch leitenden Trägerarm verbunden, der das Werkstück fest und in elektrischem Kontakt auf dem Podest hält. Der leitende Trägerarm ist durch einen Isolator von den leitenden Wänden der Kammer elektrisch isoliert. Von einem äußeren Hochspannungsimpulsgenerator werden dem Werkstück über eine Hochspannungsleitung, die mit dem Trägerarm und dem Podest verbunden ist, Hochspannungsimpulse zugeführt.

Bei dem in der Kammer erzeugten Hochvakuum wird zur Ausbildung eines das Werkstück umgebenden Plasmas (Immersion) Gas in die Kammer eingelassen. Dieses Gas ist ein Mischgas, das die für die Implantationsbehandlung benötigten Komponenten enthält. Dieses neutrale Gasgemisch innerhalb der Kammer wird beispielsweise durch einen diffusen Elektronenstrahl ionisiert, der von einer Heizwendel innerhalb der Kammer ausgeht.

Hier ist zu erwähnen, daß das oben genannte US-Patent verschiedene andere Quellen für das für die PII-Behandlung benötigte Gasgemisch erwähnt, z.B. durch Verdampfung von Flüssigkeiten und Festkörpern. Durch außerhalb der Kammer gelegene Magnetelemente wird innerhalb der Kammer ein Magnetfeld erzeugt, das die von der Elektronenquelle ausgehenden diffusen Elektronen von den Kammerwänden ab und ins Innere der Kammer hinein lenkt, wo sie mit Gasatomen oder Molekülen zusammenprallen und das Gas ionisieren können. Das obige US-Patent erwähnt weder eine Beschichtungsbehandlung von Werkstücken noch die Verwendung eines großflächigen Beschichtungsplasmas als Immersionsplasma. Ferner sieht die zuvor beschriebene, aus diesem US-Patent bekannte Apparatur nicht die Drehung des zu behandelnden Werkstücks innerhalb der Reaktionskammer vor.

Da bei den oben erwähnten plasma-immersions-gestützten Behandlungen dem Werkstück oder den Werkstücken innerhalb der Hochvakuum-Behandlungskammer Hochspannungspulse bis zu 100 kV zugeführt werden müssen, ist die Bewegung der Werkstücke mittels eines Drehantriebs nur über spezielle Konstruktionen möglich. Dies wird unter anderem erschwert durch die Gefahr von Hochspannungsüberschlägen; insbesondere besteht die Gefahr von Gleitfunkenstrecken, d.h. Entladungen entlang von Bereichen, in denen Metall, Isolierkeramik und Plasma zusammentreffen. Darüber hinaus müssen die beweglichen Teile sicher kontaktiert werden, da nur dauerhafte flächige Kontakte eine funkenfreie Spannungs- oder Stromzuführung ermöglichen.

Der Grundgedanke der plasma-immersions-gestützten Ionen-Implantation ist, daß ein Werkstück in ein Plasma eingetaucht wird, dann durch Anlegen einer gepulsten Hochspannung eine allseitige homogene Behandlung durch einen Ionen-Implantation erfährt. Durch die Ausnutzung eines Magnetron-Sputterplasmas als Immersionsplasma läßt sich dieses Verfahren der Ionen-Implantation mit Beschichtungstechniken kombinieren.

Plasmaquellen, vor allem aber Beschichtungsplasmaquellen haben oft eine gewisse Richtcharakteristik. Um nun auch in diesem Fall eine homogene gleichmäßige Behandlung des Werkstücks zu erhalten, muß dieses während des Prozesses bewegt werden. Bei bekannten Beschichtungsverfahren wird dies mittels eines Drehantriebs realisiert. Aufgrund der gepulsten Hochspannung, die beim PII-Verfahren an die Werkstücke angelegt wird, ist dies bisher allerdings für diesen PII-Prozeß nicht möglich.

EP 0729 173 A1 offenbart eine Metallionen-Implantiervorrichtung mit einem rotierbaren Substrathalter, der mittels eines Schaftes und unten angeordnetem Motorantriebs rotiert werden kann, dem im untersten Abschnitt eine Hochspannungsquelle eine negative pulsbare Substrat-Biasspannung anlegt . Der Substrathalter ist im Bereich des unten liegenden Lagers gegenüber dem Vakuumbehälter elektrisch isoliert.

GB 2 133 764 A offenbart einen Drehantrieb der gattungsgemäßen Art mit mehreren drehbaren Substrathaltern, die durch eine Art Planetenantieb relativ zur Plattform eines Vakuumgefäßes gedreht werden. Diese Druckschrift erwähnt keine spezifischen Substratbiasspannungen und auch keine elektrische Isolation des Motorantriebs von der Antriebswelle. Ein Schleifkontakt greift am untersten Abschnitt der Antriebswelle an, um eine negative Substratbiasspannung zuzuführen. Der eigentliche Motor-Drehantrieb greift unten an einer zentralen Antriebswelle an, und die einzelnen Substrathalter sind drehbar an einem an Speichen befestigten peripheren Ringabschnitt eines im Vakuumgefäß liegenden radförmigen Substrathalterträgers gelagert. Bei der Drehung des radförmigen Trägers wird durch eine Konstruktion aus sternförmigen Mitehmer- Armen auch jeder einzelne Substrathalter gedreht.

### Aufgabe der Erfindung

Es ist Aufgabe der Erfindung einen Drehantrieb, insbesondere zur plasma-immersions-gestützen Behandlung von Werkstücken, so anzugeben, daß damit kostengünstig Ionen-Implantationen sowie ionen-gestützte Niedertemperaturbeschichtungen mit hoher Haftung und Strukturqualität auch auf dreidimensional strukturierten Werkstücken mit komplexer Geometrie ohne Gefahr von Hochspannungsüberschlägen Gleitfunkenstrecken und schlechter Hochspannungszufuhr erzielbar sind.

Erfindungsgemäß wird diese Aufgabe gelöst durch eine Vorrichtung zum Drehen wenigstens eines Werkstücks, insbesondere zur Verwendung bei einer plasma-immersions-gestützten Behandlung des Werkstücks, wobei die Vorrichtung mindestens einen drehbar angetriebenen Probenhalter in Form einer drehbar gelagerten, elektrisch leitenden Probenstange, eine Hochspannungszuführung, über die der Probenstange Hochspannung zuführbar ist, erste Isolationsmittel und einen Drehantrieb aufweist, wobei die ersten Isolationsmittel die Probenstange hochspannungsfest von dem Drehantrieb isolieren und der Drehantrieb an einem ersten Ende jeder Probenstangeangreift, um diese zu drehen, dadurch gekennzeichnet, dass
die Probenstange an ihrem zweiten Ende in einem der Probenstange Hochspannungspotential zuführenden, durch zweite Isolationsmittel gegenüber einer Plattform hochspannungsfest isolierten Drehlager gelagert ist.(Patentanspruch 1)

Weitere Merkmale und Vorteile des erfindungsgemäßen Drehantriebs sind in den vom Patentanspruch 1 abhängigen Ansprüchen 2-10 angegeben. Die Patentansprüche 11-15 kennzeichnen eine bevorzugte Verwendung dieser Drehvorrichtung.

Der Kerngedanke der Konstruktion des erfindungsgemäßen Drehantriebs besteht darin, daß nicht die gesamte Vorrichtung auf Hochspannungspotential liegt, sondern die eigentlichen Antriebs- und Bewegungsteile auf Niederspannungspotential, z.B. auf Erde, im floatenden Zustand oder definiert auf bis zu 1000 V-Niveau. Die zwischen den Probenstangen und den sonstigen Antriebs- und Bewegungsteilen vorgesehenen Isolationsmittel, deren geometrische Dimensionen von der maximalen Spannung abhängen, trennen die zur Befestigung der Werkstücke dienenden Probenstangen elektrisch von den sonstigen Vorrichtungsteilen. Die Kontaktierung bzw. Zuführung der Hochspannung zu der Probenstange oder den Probenstangen erfolgt am anderen Ende derselben über flächige Schleifkontakte.

Nachstehend werden eine Ausführungsform des zur plasma-immersions-gestützen Behandlung besonders von dreidimensionalen Werkstücken dienenden Drehantriebs anhand der Zeichnung sowie anschließend Ausführungsbeispiele des erfindungsgemäßen Verfahrens beschrieben.

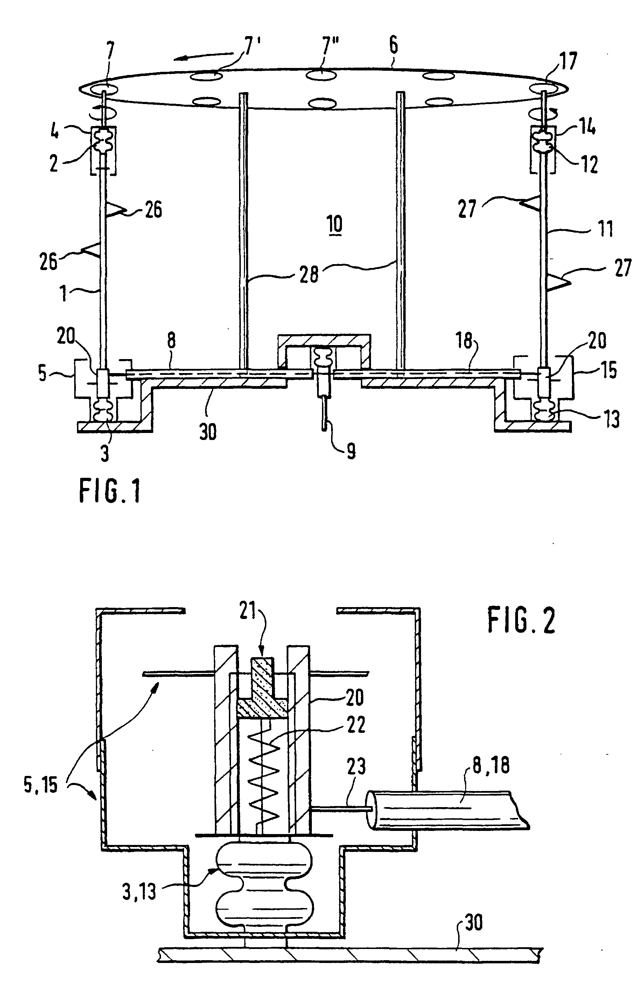

Eine bevorzugte Ausführungsform eines zur Durchführung einer plasma-immersions-gestützten Behandlung besonders von dreidimensionalen Werkstücken geeigneten Drehantriebs wird nachstehend unter Bezug auf Fig. 1, die schematisch eine Gesamtansicht des Drehantriebs zeigt, und Fig. 2 beschrieben, die schematisch und vergrößert, teilweise im Schnitt, Details eines am unteren Ende jeder Probenstange angeordneten gleichzeitig als Drehlager und Hochspannungszuführung dienenden Keramik-Isolationskörpers zeigt.

Bei dem in Fig. 1 schematisch dargestellten und allgemein mit der Ziffer 10 bezeichneten Drehantrieb befindet sich die Kraftübertragung für die Drehung an einer anderen Stelle als die Hochspannungskontaktierung und nicht die gesamte Anordnung liegt auf Hochspannungspotential sondern nur die als Probenhalter dienenden Stangen 1, 11, von denen in Fig. 1 lediglich zwei beispielhaft in paralleler senkrechter Anordnung gezeigt sind. Statt in senkrechter Lage können die Probenstangen z.B. auch in waagrechter Lage vorgesehen sein. Dagegen sind die eigentlichen Antriebs- und Bewegungsteile auf Niederspannungspotential gelegt, z.B. auf Erde, floatend oder auf ein definiertes Spannungsniveau bis 1000 V. Zur Isolation befinden sich am oberen Ende der Probenstangen 1, 11 als erste Isolationsmittel dienende Keramik-Isolationskörper 2, 12, deren geometrische Dimensionen von der höchsten den Probenstangen 1, 11 zugeführten Hochspannung abhängen. Der am oberen Ende der Probenstangen 1, 11 angreifende und diese drehende Drehantrieb, der durch schematisch als Kreise 7, 7', 7", 17 dargestellte Antriebsräder angedeutet ist, ist demnach durch die Keramik-Isolationskörper 2, 12 gegenüber den Hochspannung führenden Probenstangen 1, 11 isoliert. Die Antriebsräder 7, 7', 7", 17 sind ihrerseits an einem separat drehbar angetriebenen Drehteller 6 gelagert und können z.B. reibschlüssig angetriebene Scheiben oder bevorzugt form- und kraftschlüssig von einem Getriebe gemeinsam angetriebene Ritzel sein.

Die am oberen Ende der darin zentral, senkrecht und herausnehmbar befestigten Probenstangen 1, 11 liegenden Keramik-Isolationskörper 2, 12 werden mit den Probenstangen 1, 11 gedreht. Sie sind zusätzlich durch Metallbecher 4, 14 geeigneter Form vor Bedampfung oder vor beschichtendem Plasma geschützt.

Damit die beschichtenden Plasmen in dem erfindungsgemäßen Drehantrieb unter gleichzeitiger Zuführung der Hochspannungspulse genutzt werden können, dienen diese als Metallbecher gestaltete Abschirmbleche und Abdeckungen dazu, die isolierenden Keramikkörper vor einer metallischen (leitfähigen) Beschichtung zu beschützen. Diese Blechbecher sind wesentlich für den Gebrauch in beschichtenden Plasmen, können aber auf viele geometrisch denkbare Arten realisiert werden. Solche Abschirmungen bewirken darüber hinaus, daß das Plasma nicht an alle hochspannungsführenden Teile gelangt und zu unnötigen Strömen über den Drehantrieb führt, was eine Strombelastung des Pulsgenerators und Aufheizung des Drehantriebes bewirken würde. Bei der Abschirmung ist zu beachten, daß die maximal anlegbare Spannung vor allem von Abständen hochspannungsführender Teile zu anderen nicht hochspannungsführenden Teilen abhängt. Im Vakuum oder bei einem Arbeitsdruck von 0,01-1 Pa genügen in der Regel Abstände von 10 mm für deutlich höhere Spannungen als 30 kV.

Die Probenstangen sind durch (nicht gezeigte) Bajonettverschlüsse in den oberen Keramik-Isolationskörpern 2, 12 verriegelt. Zur Halterung der Werkstücke bzw. ?roben sind an den Probenstangen 1, 11 schematisch Klemmen 26 und 27 angedeutet.

Die oben geschilderten Probenstangen 1, 11 sind an ihrem unteren Ende ebenfalls durch Keramik-Isolationskörper 3, 13 gegenüber einem plattformartigen mit dem Drehteller 6 drehbaren Sockel 30 isoliert. Auch diese unteren Keramik-Isolationskörper 3, 13 sind durch geeignet geformte Metallbecher 5, 15 gegen Bedampfung und vor beschichtendem Plasma geschützt.

Fig. 1 zeigt außerdem eine zentrale Hochspannungszuführung 9, die über Abzweigungen 8, 18 zu dem Fußpunkt der Probenstangen 26, 27 geführt ist. Weiterhin sind Stützsäulen 28 angedeutet, die den gesamten Drehantrieb gegenüber der drehbaren Plattform 30 abstützen.

Fig. 2 zeigt vergrößert und im Detail die am unteren Ende der Probenstangen 1, 11 angeordneten kombinierten Hochspannungszuführungen und Lager, die jeweils an den unteren Keramik-Isolationskörpern 3 bzw. 13 befestigt sind. Dazu ist zentral am Keramik-Isolationskörper 3, 13 eine bevorzugt aus Messing oder alternativ aus einem anderen gut leitenden Material bestehende Metallbuchse 20 befestigt, die das Drehlager für die jeweilige Probenstange 1, 11 bildet, die sich darin reibarm drehen kann. An der unteren Stirnfläche der Probenstangen 1, 11 liegt ein in der Messingbuchse längsbeweglicher, durch eine Schraubenfeder 22 vorgespannter Graphitschleifkontaktstift 21 an, zu dem die Hochspannung über die Hochspannungszuführung 8, 18 bzw. 23 geführt ist. Diese Art der Hochspannungskontaktierung ähnelt der der zentralen Spannungszuführung in einem Zündverteiler in der Automobilelektrik. Auch dort werden dem Zündverteiler über einen Graphitschleifkontakt Spannungspulse bis zu wenigen 10 kV zugeführt.

Bei der in Fig. 2 gezeigten Anordnung liegen die unteren Stirnflächen der Probenstangen 1, 11 flächig an dem Graphitstift 21 an. Die Messingbuchse 20 ist in ihrem unteren Teil durch einen einfachen Kupferdraht mit der in einem Keramik- oder Metallrohr 8, 18 abgeschirmt und isoliert geführten Hochspannungsleitung 23 verbunden.

Die obige Beschreibung macht deutlich, daß ein Großteil des Drehantriebs mit daran befestigten Halterungen auf Erd- oder Floatingpotential liegt und daß lediglich die davon hochspannungsfest isolierten, exzentrisch gelagerten Probenstangen 1, 11 mit den Befestigungselementen 26 und 27 auf Hochspannung liegen.

Der erfindungsgemäße Drehantrieb hat zwei (nicht gezeigte) Motoren außerhalb der Vakuumkammer, die über geeignete, ebenfalls nicht gezeigte Vakuumdrehdurchführungen ein Zahnradplanetengetriebe in der Vakuumkammer antreiben. Damit sind zwei Drehbewegungen realisiert, d.h. der Drehteller 6 führt zusammen mit der über die Stützsäule 28 verbundenen drehbaren Plattform 30 und den Probenstangen 1, 11 eine Drehbewegung um eine (nicht gezeigte) senkrechte Drehachse aus, und die Probenstangen 1, 11 drehen sich jeweils einzeln. Obwohl in Fig. 1 beispielhaft nur zwei Probenstangen 1, 11 gezeigt sind, kann durch entsprechende Auslegung des Drehtellers 6 und der Antriebsritzei 7, 7', 7", 17 eine beliebige Anzahl von, z.B. 8, im Kreis angeordneten Probenstangen vorgesehen sein.

Mit dem oben anhand der Figuren 1 und 2 beschriebenen Ausführungsbeispiel eines Drehantriebs lassen sich viele Werkstücke zur Durchführung einer plasma-immersions-gestützen Behandlung so bewegen, daß eine kostengünstige, homogene und temperaturstabile Beschichtung möglich ist. Bisher werden Plasma-Immersions-Prozesse mit feststehenden Werkstücken durchgeführt (vgl. das oben genannte US-Patent 4 764 394), was bei Nitrier- und CVD-Prozessen möglich ist. In PVD-Prozessen unter Nutzung von Plasmaquellen mit Richtcharakteristik ist eine homogene Behandlung nur möglich, falls die Werkstücke gleichmäßig bewegt werden können. Durch den erfindungsgemäßen Drehantrieb ist durch Ein- und Ausfahren der Teile in das Plasma und aus dem Plasma eine Temperaturstabilisierung im Prozeß möglich.

Nun folgen drei verschiedene Ausführungsbeispiele von plasma-immersions-gestützen Sustratbehandlungen, die den beschriebenen Drehantrieb vorteilhaft einsetzen:
I.
   Verwendung eines Beschichtungsplasmas als Immersionsplasma zur Ionen-Implantation:
   - Plasma von plasmagestützten Beschichtungsverfahren aus Gasphasen (CVD), erzeugt durch selbständige Gleichspannungsentladung;
   - Plasma von plasmagestützten Beschichtungsverfahren aus Gasphasen (CVD), erzeugt durch Hochfrequenz- oder Mikrowellenanregung;
   - Gasmischungen, bestehend aus Inertgasen (z.B. Argon), Reaktivgasen (z.B. Stickstoff, Kohlenwasserstoffe, Sauerstoff, Fluor-, Bor- oder Chlorverbindungen) und schichtbildenden Monomeren (Siliziumverbindungen, Kohlenwasserstoffe, Metallorganika);
   - Plasma von plasma- bzw. ionengestützten Beschichtungsverfahren aus Feststoffen (PVD), wie unbalanciertes Magnetronsputtern und Bogenverdampfen, erzeugt durch Gleichspannung;
   - dito, erzeugt durch Hochfreauenzentladung;
   - Gasmischungen, bestehend aus Inertgasen (z.B. Argon), Reaktivgasen (z.B. Stickstoff, Kohlenwasserstoffe, Sauerstoff, Fluor-, Bor-, Silizium- oder Chlorverbindungen) ;
   - Plasma von kombinierten plasmagestützen CVD/PVD-Prozessen;
   - Anlegen von positiven oder negativen Hochspannungspulsen, abhängig vom Material des zu behandelnden Werkstücks, Spannungspegel 1 kV - 100 kV, Hochspannungspulse variabler Länge und Frequenz.
II.
   Ionenunterstützung bei Beschichtungsverfahren durch Eintauchen (Immersion) der Werkstücke in das Beschichtungsplasma und Anlegen negativer Hochspannungspulse von 1 kV - 100 kV und variabler Länge und Frequenz an die Werkstücke.
   - Beschichtung und Ionenbehandlung abwechselnd;
   - Beschichtung und Ionenbehandlung gleichzeitig;
   - Kombination von Beschichtungen ohne Ionenunterstützung mit solchen mit Plasma-Immersions-Ionenbehandlung wechselnd oder gleichzeitig.
   Mit den obigen erfindungsgemäßen Verfahren I und II läßt sich eine Vielzahl von Werkstoffen behandeln:
   - Metalle, Metallegierungen mit negativen Hochspannungspulsen;
   - Isolatoren und Kunststoffe durch bipolare Spannungspulse unterschiedlichen Spannungspegels zum Ionenbeschuß (z.B. -1 kV bis -100 kV) und zur Abfuhr der dabei aufgetragenen positiven Ladung (z.B. +0 kV bis +1 kV).
III.
   Realisation kombinierter PVD/PII-Verfahren durch Anlegen bipolarer Spannungspulse an die Werkstücke mit unterschiedlich hohen negativen bzw. positiven Niveaus:
   - Während positiver Pulse (z.B. +0 kV bis +1 kV) erfolgt Bogenverdampfung bzw. Zerstäubung der umliegenden kathodisch geschalteten Elektrodenfläche entlang der Anlagenwand;
   - während negativer Pulse (z.B. -1 kV bis -100 kV) erfolgt Plasma-Immersions-Ionenbehandlung.

## Patentansprüche

1. Vorrichtung zum Drehen wenigstens eines Werkstücks, insbesondere zur Verwendung bei einer plasma-immersions-gestützten Behandlung des Werkstücks, wobei die Vorrichtung (10) mindestens einen drehbar angetriebenen Probenhalter in Form einer drehbar gelagerten, elektrisch leitenden Probenstange (1, 11), eine Hochspannungszuführung (8, 9, 18, 23), über die der Probenstange (1, 11) Hochspannung zuführbar ist, erste Isolationsmittel (2, 12) und einen Drehantrieb (6, 7, 7', 17) aufweist, wobei die ersten Isolationsmittel (2, 12) die Probenstange (1, 11) hochspannungsfest von dem Drehantrieb (6,7,7',17) isolieren und der Drehantrieb (6, 7, 7', 17) an einem ersten Ende jeder Probenstange (1,11) angreift, um diese zu drehen,
**dadurch gekennzeichnet, dass**
die Probenstange (1, 11) an ihrem zweiten Ende in einem der Probenstange (1,11) Hochspannungspotential zuführenden, durch zweite Isolationsmittel (3, 13) gegenüber einer Plattform (30) hochspannungsfest isolierten Drehlager (20, 21) gelagert ist.

2. Vorrichtung nach Anspruch 1, **dadurch gekennzeichnet, dass** der Drehantrieb an dem ersten Ende der Probenstange (1, 11) unter Zwischenlage der ersten Isolationsmittel (2, 12) angreift.

3. Vorrichtung nach Anspruch 2, **dadurch gekennzeichnet, dass** die ersten Isolationsmittel (2, 12) jeweils als Keramikisolator gestaltet sind, in dem die jeweilige Probenstange (1, 11) isoliert und zentrisch befestigt ist und der sich mit der Probenstange (1, 11) dreht.

4. Vorrichtung nach Anspruch 1, **dadurch gekennzeichnet, dass** die Probenstange(n) Befestigungselemente, insbesondere Klemmen (26, 27), für Werkstücke aufweist bzw. aufweisen.

5. Vorrichtung nach einem der vorangehenden Ansprüche, **dadurch gekennzeichnet, dass** die Probenstange(n) (1, 11) senkrecht zwischen den ersten und zweiten Isolationsmitteln (2, 12 und 3, 13) gelagert ist bzw. sind, wobei die ersten Isolationsmittel (2, 12) oben und die zweiten Isolationsmittel (3, 13) unten angeordnet sind.

6. Vorrichtung nach Anspruch 1 oder 5, **dadurch gekennzeichnet, dass** die zweiten Isolationsmittel (3, 13) als an der anliegenden Plattform (30) befestigte Keramikstützisolatoren mit einer daran zentrisch angeordneten, ein Drehlager bildenden Metallbuchse (20) gestaltet sind, in der sich die Probenstange(n) jeweils reibarm drehen kann bzw. können.

7. Vorrichtung nach Anspruch 6, **dadurch gekennzeichnet, dass** ein mit der Metallbuchse (20) verbundener Schleifkontakt (21) einen flächigen Hochspannungskontakt mit der bzw. den Probenstange(n) (1, 11) herstellt.

8. Vorrichtung nach Anspruch 7, **dadurch gekennzeichnet, dass** der Schleifkontakt (21) einen an der Stirnfläche der Probenstange anliegenden Graphitstift aufweist.

9. Vorrichtung nach einem der Ansprüche 1 bis 8, **dadurch gekennzeichnet, dass** mehrere parallele Probenstangen (1, 11) zur Aufnahme mehrerer Werkstücke vorgesehen sind und der Drehantrieb zwei getrennte Antriebsmotoren sowie getrennte Kraftübertragungen derart aufweist, daß die Probenstangen (1, 11) für sich als auch insgesamt gemeinsam mit der Plattform (30) drehbar sind.

10. Vorrichtung nach einem der Ansprüche 1 bis 9, **dadurch gekennzeichnet, dass** die als Isolationsmittel dienenden Keramikisolatoren durch geeignet geformte Metall-Abschirmbecher und Metallabdeckungen gegen eine Beschichtung im Plasma geschützt sind, die gegenüber der /den hochspannungsführenden Probenstange(n) (1, 11) isoliert sind.

11. Verfahren zur plasma-immersions-gestützten Behandlung insbesondere dreidimensional geformter Werkstücke, **dadurch gekennzeichnet, dass** das Werkstück oder die Werkstücke in ein Plasma eintauchen und mit einer Vorrichtung nach einem der Ansprüche 1-10 gedreht wird bzw. werden.

12. Verfahren nach Anspruch 11, **dadurch gekennzeichnet, dass** das Werkstück mit einer periodisch gepulsten Hochspannung beaufschlagt wird.

13. Verfahren nach Anspruch 12, **dadurch gekennzeichnet, dass** negative oder bipolare Hochspannungsimpulse von 1 kV bis 100 kV mit variabler Länge und Frequenz eingesetzt werden.

14. Verfahren nach einem der Ansprüche 11 bis 13, **dadurch gekennzeichnet, dass** die Behandlung eine Beschichtung und eine Ionenbehandlung der Werkstücke umfasst, wobei diese Behandlungen gleichzeitig oder abwechselnd erfolgen.

15. Verfahren nach einem der Ansprüche 11 bis 14, **dadurch gekenneichnet, dass** die Behandlung eine Beschichtung der Werkstücke ohne Ionenbehandlung und eine Beschichtung der Werkstücke mit Plasma-Immersions-Ionenbehandlung umfasst, die wechselnd oder gleichzeitig erfolgen.

## Claims

1. Device for rotating at least one workpiece, in particular for use in a plasma immersion-assisted treatment of the workpiece, the device (10) having at least one rotatably driven sample holder in the form of a rotatably mounted, electrically conductive sample rod (1, 11), a high-voltage lead-in (8, 9, 18, 23) through which high voltage can be delivered to the sample rod (1, 11), first insulation means (2, 12) and a rotary drive (6, 7, 7', 17), the first insulation means (2, 12) insulating the sample rod (1, 11) from the rotary drive (6, 7, 7', 17)in a manner withstanding high voltage and the rotary drive (6, 7, 7', 17) engaging at a first end of each sample rod (1, 11) in order to rotate it, **characterized in that** the sample rod (1, 11) is mounted at its second end in a pivot bearing (20, 21) which delivers high-voltage potential to the sample rod (1, 11) and is insulated by second insulation means (3, 13), in a manner withstanding high voltage, with respect to a platform (30).

2. Device according to Claim 1, **characterized in that** the rotary drive engages at the first end of the sample rod (1, 11), with interposition of the first insulation means (2, 12).

3. Device according to Claim 2, **characterized in that** the first insulation means (2, 12) are each configured as a ceramic insulator in which the respective sample rod (1, 11) is fastened in an insulated and centred manner, and which rotates with the sample rod (1, 11).

4. Device according to Claim 1, **characterized in that** the sample rod(s) has or have fastening means, in particular clamps (26, 27), for workpieces.

5. Device according to one of the preceding claims, **characterized in that** the sample rod(s) (1, 11) is or are mounted vertically between the first and second insulation means (2, 12 and 3, 13), the first insulation means (2, 12) being arranged at the top and the second insulation means (3, 13) at the bottom.

6. Device according to Claim 1 or 5, **characterized in that** the second insulation means (3, 13) are configured as ceramic support insulators, fastened to the adjacent platform (30), having a metal bushing (20) arranged centrally on them which forms a pivot bearing and in which the sample rod(s) can each rotate in a low-friction manner.

7. Device according to Claim 6, **characterized in that** a wiper contact (21) connected to the metal bushing (20) creates a planar high-voltage contact to the sample rod(s) (1, 11).

8. Device according to Claim 7, **characterized in that** the wiper contact (21) has a graphite pin bearing on the end surface of the sample rod.

9. Device according to one of claims 1 to 8, **characterized in that** a plurality of parallel sample rods (1, 11) for holding a plurality of workpieces are provided, and the rotary drive has two separate drive motors as well as separate power transfer systems, such that the sample rods (1, 11) are rotatable together with the platform (30) both individually and as a group.

10. Device according to one of claims 1 to 9, **characterized in that** the ceramic insulators serving as insulation means are protected against coating in the plasma by suitably shaped metal screening cups and metal covers, which are insulated with respect to the sample rod(s) (1, 11) carrying high voltage.

11. Method for plasma immersion-assisted treatment of, in particular, three-dimensionally shaped workpieces, **characterized in that** the workpiece or workpieces is or are immersed in a plasma and rotated by a device according to one of claims 1 to 10.

12. Method according to Claim 11, **characterized in that** a periodically pulsed high voltage is applied to the workpiece.

13. Method according to Claim 12, **characterized in that** negative or bipolar high-voltage pulses of from 1 kV to 100 kV are used.

14. Method according to one of Claims 11 to 13, **characterized in that** the treatment comprises coating and ion treatment of the workpieces, these treatments taking place simultaneously or alternately.

15. Method according to one of Claims 11 to 14, **characterized in that** the treatment comprises coating of the workpieces without ion treatment and coating of the workpieces with plasma-immersion ion treatment, which take place alternately or simultaneously.

## Revendications

1. Dispositif pour tourner au moins une pièce, notamment applicable à un traitement de pièces avec immersion dans du plasma,
le dispositif (10) comportant au moins un support d'échantillon entraîné en rotation et ayant la forme d'une tige échantillon (1, 11) conductrice électrique, montée à rotation, une alimentation à haute tension (8, 9, 18, 23) pour appliquer la haute tension à la tige échantillon (1, 11), des premiers moyens d'isolation (2, 12) et un entraînement en rotation (6, 7, 7', 17), les premiers moyens d'isolation (2, 12) isolant la tige échantillon (1, 11) de manière à résister à une haute tension, par rapport à l'entraînement en rotation (6, 7, 7', 17), alors que l'entraînement en rotation (6, 7, 7', 17) agit sur une première extrémité de chaque tige échantillon (1, 11) pour la tourner,
**caractérisé en ce que**
la tige échantillon (1, 11) est montée par sa seconde extrémité dans un palier de rotation (20, 21) isolé en haute tension par rapport à une plate-forme (30), et qui fournit le potentiel de haute tension à la tige échantillon (1, 11) à travers des seconds moyens d'isolation (3, 13).

2. Dispositif selon la revendication 1,
**caractérisé en ce que**
l'entraînement en rotation agit sur la première extrémité de la tige échantillon (1, 11) avec interposition des premiers moyens d'isolation (2, 12).

3. Dispositif selon la revendication 2,
**caractérisé en ce que**
les premiers moyens d'isolation (2, 12) sont réalisés chaque fois comme des isolateurs en céramique dans lesquels la tige échantillon (1, 11) respective est fixée de manière isolée et centrée, et ce moyen d'isolation tourne avec la tige échantillon (1, 11).

4. Dispositif selon la revendication 1,
**caractérisé en ce que**
la ou les tiges échantillons comportent des éléments de fixation notamment des pinces (26, 27) pour les pièces.

5. Dispositif selon l'une des revendications précédentes,
**caractérisé en ce que**
la ou les tiges échantillons (1, 11) sont montées verticalement entre les premiers et les seconds moyens d'isolation (2, 12, et 3, 13) et les premiers moyens d'isolation (2, 12) sont montés en haut et les seconds moyens d'isolation (3, 13) en bas.

6. Dispositif selon l'une des revendications 1 ou 5,
**caractérisé en ce que**
les seconds moyens d'isolation (3, 13) sont des isolateurs d'appui en céramique fixés à la plate-forme (30) adjacente, avec une douille métallique (20) centrale, formant un palier de rotation et dans laquelle la ou les tiges échantillons peuvent tourner à faible frottement.

7. Dispositif selon la revendication 6,
**caractérisé en ce qu'**
un contact balai (21) relié à la douille métallique (20) forme un contact de haute tension en surface avec la ou les tiges échantillons (1, 11).

8. Dispositif selon la revendication 7,
**caractérisé en ce que**
le contact à balai (21) comporte une tige en graphite appliquée contre la face frontale de la tige échantillon.

9. Dispositif selon l'une quelconque des revendications 1 à 8,
**caractérisé par**
plusieurs tiges échantillons (1, 11), parallèles pour recevoir plusieurs pièces et l'entraînement en rotation comprend deux moteurs séparés ainsi que des transmissions de force séparées, de façon que les tiges échantillons (1, 11) puissent tourner en soi et aussi globalement avec la plate-forme (30).

10. Dispositif selon l'une quelconque des revendications 1 à 9,
**caractérisé en ce que**
les isolateurs en céramique servant de moyens d'isolation sont protégés par des écrans de rupture métalliques de forme appropriée et des recouvrements métalliques contre un revêtement dans le plasma et ils sont isolés par rapport aux tiges échantillons (1, 11) à la haute tension.

11. Procédé de traitement notamment de pièces de forme tridimensionnelle assistées par immersion dans du plasma,
**caractérisé en ce qu'**
on plonge la pièce ou les pièces dans un plasma et on les fait tourner avec un dispositif selon l'une quelconque des revendications 1 à 10.

12. Procédé selon la revendication 11,
**caractérisé en ce que**
la pièce est mise à une haute tension pulsée périodiquement.

13. Procédé selon la revendication 12,
**caractérisé par**
des impulsions de haute tension négatives ou bipolaires de 1 kV à 100 kV, de longueur et de fréquence variables.

14. Procédé selon l'une quelconque des revendications 11 à 13,
**caractérisé en ce que**
le traitement comprend l'application d'un revêtement et un traitement ionique des pièces, ces traitements se faisant simultanément ou en alternance.

15. Procédé selon l'une quelconque des revendications 11 à 14,
**caractérisé en ce que**
le traitement est un revêtement des pièces en traitement ionique et un revêtement des pièces avec traitement ionique à immersion dans du plasma, et ces traitements se font de manière alternée ou simultanée.
